# EUROPEAN PATENT APPLICATION

(11) **EP 1 174 966 A2**
(43) Date of publication of application: **23.01.2002**
(21) Application number: 01115115.6
(22) Date of filing: 21.06.2001
(51) Int. Cl.: H01S 5/065, H01S 5/0625

(54) **Method and apparatus for driving mode-locked semiconductor laser**

(30) Priority: 13.07.2000 JP 2000212510
(71) Applicant: NEC CORPORATION, Tokyo (JP)
(72) Inventor: Ogura, Ichiro, Tokyo (JP)
(74) Representative: Baronetzky, Klaus, Dipl.-Ing.

(57) **Abstract**

The invention includes: a mode-locked semiconductor laser having at least a light amplification region 12, a saturable absorbing region 11, a resonator length adjusting region 14, and an optical modulation region 13 for forcedly modulating a light intensity externally in such a configuration that when a reverse bias voltage is applied to the saturable absorbing region and a current is injected to the light amplification region, passive mode-locking occurs, and a natural oscillation is adjusted according to a bias applied to the resonator length adjusting region; an oscillator 15 for applying a sine wave having a reference frequency to the optical modulation region to thereby carry out forced optical modulation; a photo-detector 30 for photo-electrically converting an output light of the mode-locked semiconductor laser into an electric signal; a driving device 34 for supplying a bias to the resonator length adjusting region; a noise detecting device 32 for receiving an output of the photo-detector as an input to thereby extract a low-frequency noise component; and a control device 33 for adjusting a bias for the resonator length adjusting region by controlling the driving device so as to minimize the intensity of the noise component.

## Description

### BACKGROUND OF THE INVENTION

### 1. Field of the Invention

The invention relates to a method and an apparatus for driving a mode-locked semiconductor laser used in optical communication, optical instrumentation, optical information processing, etc.

### 2. Description of the Related Art

There have recently been increasing demands for a larger capacity in optical communication and also been made many discussions of a device and an approach which can meet the demands. The large capacity optical communication approach mainly comes in a wavelength multiplexing method and a time division multiplexing method, which may be used in combination to constitute a realistic large capacity communication system.

Of a variety of time division multiplexing methods, an optical time division multiplexing method employing a pulsed light is attracting the attention. By this method, an ultrashort optical pulse in a pico-second order is modulated as a signal by an optical modulator for each channel and then combined with delay at regular intervals, thus obtaining a time-divided optical signal string at an ultra-high speed in excess of 100 giga bits/second.

A mode-locked semiconductor laser can generate an ultrashort optical pulse in a pico-second order comparatively easily and in a stable manner, thus being desirable as a light source in optical communication.

Since a communication system has its own reference frequency regulated restrictively, to use the mode-locked semiconductor laser in optical communication, a repetition frequency of its optical pulses must be fixed to the reference frequency to synchronize its optical pulse output with that communication system.

To this end, a method for driving the mode-locked semiconductor laser typically employs active mode-locking for externally applying a sine wave having the reference frequency for forced optical modulation to thereby fix a frequency to the reference frequency or hybrid mode-locking combining this active mode-locking and passive mode-locking.

A problem of this method is that a range within which the frequency can be fixed is as narrow as about 0.1% of the reference frequency, so that it is difficult to confine in this range a natural frequency of a resonator for the mode-locked semiconductor laser.

That is, the natural frequency of a mode-locked semiconductor laser is given as an inverse number of a time for an optical pulse to reciprocate in a laser resonator and so the natural frequency is uniquely determined by the length of the optical resonator of a semiconductor laser employed, which however is usually formed by cleavage (cleavage of both end faces of the laser), so that it is extremely difficult to conduct control with a good reproducibility at the required frequency accuracy of 0.1%, i.e. 1 µm calculated as the resonator length or better.

An error encountered during a typical mechanical cleavage process is usually 10 µm or so, i.e. 1% calculated as a frequency accuracy at best, thus resulting in an extremely low yield of devices capable of fixation at the reference frequency.

To solve this problem of cleavage accuracy, a method has been discussed for externally changing the optical length of a resonator to thereby correct a shift in frequency. The method includes, for example, the following:
(1) method for electrically changing the refractive index of an optical wave guide by injecting a current or applying an electric field; and
(2) method for changing the effective length of a distributed reflecting mirror provided at an end of a resonator.

The second method is disclosed for example in Japanese Patent Application Laid-Open No. Hei 10-359584, in which an electric field absorbing effect is employed to permit an optical absorption loss in the distributed reflecting mirror to be changed by external application of an electric field in order to change the effective length of the distributed reflecting mirror, i.e. the depth by which a light penetrates into the distributed reflecting mirror, thus correcting the mode-locking frequency.

Although such a method can externally match the frequency of a mode-locked semiconductor laser with the reference frequency, a relevant apparatus must include additional terminals for adjusting the frequency and so may be complicated in driving.

To avoid this complication in driving, the frequency needs to be adjusted automatically.

To automatically match the frequency of a mode-locked semiconductor laser with a reference frequency, a shift in frequency needs to be detected to thereby conduct feed-back control over the frequency adjusting region.

As the automatic frequency adjusting method has conventionally been known such a typical method as called a Phase locked Loop (PLL) method. According to this method, an output frequency of a Voltage Controlled Oscillator (VCO) is matched with a frequency of a reference oscillator by specifically detecting an error in frequency with respect to a reference signal to smooth a signal corresponding to a phase difference using a loop filter and then supply thus smoothed signal as a control voltage to the voltage controlled oscillator, thus in turn feeding back an output of the voltage controlled oscillator to a phase frequency comparator.

Since a mode-locked semiconductor laser capable of changing its frequency by an external voltage operates almost the same way as a voltage controlled oscillator, an attempt may be made for automatic control for this purpose by use of a PLL, an example of which is reported in Reference Literature 1 (see "Stable pico-second pulse generation at 46 GHz by mode-locking of a semiconductor laser operation in an optoelectronic phase-locked loop" in pp. 69-71, Vol 30, "Electronics Letters", 1994).

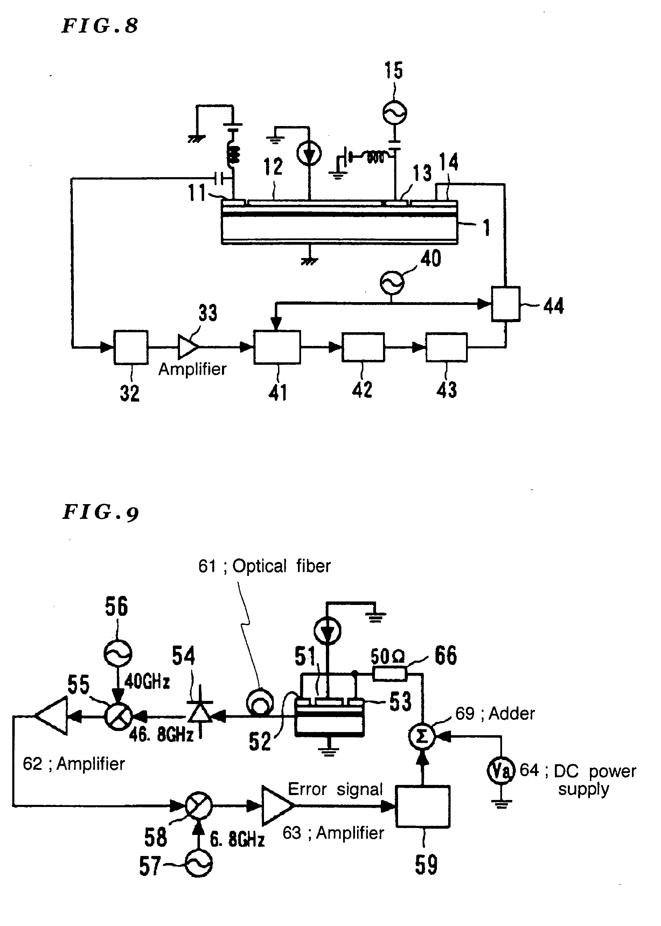

The following will describe a configuration given in the above-mentioned reference literature 1. FIG. 9 shows an extracted portion associated with a PLL operation of the configuration explained in the reference literature 1.

As shown in FIG. 9, a mode-locked semiconductor laser has three electrodes of a light amplification region 51 positioned at the center and saturable absorbing regions 52 and 53 positioned on both sides thereof, with about 46.8 GHz of a repetition frequency of a mode-locked pulse being generated by a resonator having a whole length of 810 µm.

The pulse repetition frequency can be changed within a range of 5 MHz when a voltage is applied to the saturable absorbing regions 52 and 53, thereby forming a PLL.

An optical pulse string, once emitted, is received through an optical fiber 61 at a photo-detector 54 to be converted into an electric signal, which is then mixed at a first mixer 55 with a 40-GHz signal from a signal source 56 to provide a signal with a beat frequency of 6.8 GHz.

This signal is amplified at an amplifier 62 and then compared in phase at a second mixer 58 to a 6.8-GHz reference signal from a signal source 57, so that thus obtained error signal is selectively amplified at an active loop filter 59 and then added at an adder 65 to a supply voltage from a DC power supply 64 and then applied to the saturable absorbing regions 52 and 53, thus forming a feed-back loop.

By the above-mentioned configuration, the frequency of the mode-locked semiconductor is fixed (locked) to 46.8 GHz, a sum of frequencies of the signal sources 56 and 57.

The method of employing a PLL, however, has two problems of a limited range of available frequencies and a limited range of lockable frequencies.

The first problem of limited frequency range means that a phase comparator is required having a speed equivalent to a repetition frequency of light pulses, so that its electrical response speed limits the operating frequency.

In the configuration shown in FIG. 9, the mixer circuit is two-staged for down conversion of a frequency to thereby accommodate higher frequencies, which however requires the mixer 55 for operation at a high frequency of 40 GHz.

For operation at higher frequencies, an attempt has been made to use a harmonic mixer based on frequency multiplication or to accelerate the operation utilizing optical non-linearity such as four-optical-wave mixing, which however leads to a problem of a complicated and large sized configuration.

The second problem of limited lockable frequency range means that higher stability of the feed-back loop results in a frequency band being more limited by the loop filter and that a delay time through the loop limits a lockable frequency range, usually down to 1 MHz or so.

This lockable range is almost the same as or less than a locking range in active mode-locking by which a mode-locked semiconductor laser is forcedly modulated for frequency locking and so cannot be applied to locking in the above-mentioned case where the frequency error is 1% or so due to an error in manufacturing of the mode-locked semiconductor laser.

### SUMMARY OF THE INVENTION

In view of the above, it is a main object of the invention to provide a method and an apparatus that can match a frequency of a mode-locked semiconductor laser with a reference frequency even when a difference is large between the reference frequency and a natural frequency of the mode-locked semiconductor laser. The above and other objects, advantages, and features of the invention will be more apparent to those skilled in the art from the following description.

By a method achieving the above-mentioned object for driving a mode-locked semiconductor laser related to the invention, simultaneously with forced optical modulation, intensity noise of an optical pulse output of a mode-locked semiconductor laser is detected to then minimize this intensity noise by appropriately driving a frequency adjusting region of the mode-locked semiconductor laser, thus adjusting the frequency. This object can be achieved likewise also by any of the claims of the invention.

### BRIEF DESCRIPTION OF THE DRAWINGS

FIG. 1 is an illustration for showing a first embodiment of the invention;
FIG. 2 is an illustration for showing a configuration of a mode-locked semiconductor laser according to the embodiment of FIG. 1;
FIG. 3 is a graph for indicating a relationship between a frequency and a control voltage of the mode-locked semiconductor laser of FIG. 1;
FIG. 4 is a graph for indicating a relationship between low-frequency intensity noise and a control voltage of the mode-locked semiconductor laser of FIG. 1;
FIG. 5 is a graph for indicating a frequency spectrum of the mode-locked semiconductor laser of FIG. 1 when it is stabilized to a reference frequency;
FIG. 6 is an illustration for showing a second embodiment;
FIG. 7 is an illustration for showing a third embodiment;
FIG. 8 is an illustration for showing a fourth embodiment of the invention; and
FIG. 9 is an illustration for showing a prior art method for driving a mode-locked semiconductor laser.

### DESCRIPTION OF THE PREFERRED EMBODIMENTS

The following will describe embodiments of the invention. When forced optical modulation is carried out by externally applying a sine wave having a reference frequency to a mode-locked semiconductor laser and if thus applied reference frequency matches with a natural frequency of the mode-locked semiconductor laser, a frequency locking phenomenon occurs by which an optical pulse output of the mode-locked semiconductor laser is synchronized with the reference signal.

If one observes intensity noise of the output pulsed light during this locking phenomenon, he will clearly know such a correlation that the intensity fluctuation is reduced to a minimum under the conditions that the forced modulation has a heaviest action.

By utilizing this correlation, the frequency region of the mode-locked semiconductor laser can be driven or the operating temperature thereof can be adjusted to adjust a frequency so as to minimize the intensity noise, thus matching the frequency with the reference frequency.

Since a change in this intensity noise can be clearly observed up to a frequency range of 1 GHz or so, it can be detected by a simple electric circuit operating at a relatively low frequency, thus making up a feed-back loop.

The invention comprises:
a mode-locked semiconductor laser including at least a light amplification region (12), a saturable absorbing region (11), a resonator length adjusting region (14), and an optical modulation region (13) for forcedly modulating light intensity externally in such a configuration that when a reverse bias voltage is applied to the saturable absorbing region (11) and a current is injected to the light amplification region (12), passive mode-locking occurs so that a natural frequency may be adjusted by a bias applied to the resonator length adjusting region (14);
an oscillator (15) for conducting forced optical modulation by applying a sine wave having a reference frequency to the optical modulation region (13);
a photo-detector (30) for photo-electrically converting an output light of the mode-locked semiconductor laser into an electric signal;
a driving device (34) for supplying a bias to the resonator length adjusting region;
a noise detecting device (32) for receiving an output of the photo-detector (30) as an input and extracting a noise component having a low frequency; and
a control device (33) for controlling the driving device to adjust a bias supplied to the resonator length adjusting region in such a manner as to minimize the intensity of the noise component.
Also, the invention comprises:
a mode-locked semiconductor laser including at least a light amplification region, a saturable absorbing region (11), a resonator length adjusting region (14), and an optical modulation region (13) for forcedly modulating light intensity externally in such a configuration that when a reverse bias voltage is applied to the saturable absorbing region (11) and a current is injected to the light amplification region (12), passive mode-locking occurs so that a natural frequency may be adjusted by a bias applied to the resonator length adjusting region (14);
an oscillator (15) for conducting forced optical modulation by applying a sine wave having a reference frequency to the optical modulation region (13);
a photo-detector (31) for photo-electrically converting an output light of the mode-locked semiconductor laser into an electric signal;
   a low-frequency oscillator (40) for applying a sine wave to the resonator length adjusting region (10);
a low-pass filter (32) for extracting a low-frequency noise component from an output of the photo-detector (31);
a multiplier (41) for multiplying the noise component and a signal from the low-frequency oscillator (40) in a matched phase;
an integrator (42) for integrating an output of the multiplier (41);
an error amplifier (43) for adjusting a bias to the resonator length adjusting region to reduce to zero an output of the integrator in such a way that when the natural frequency of the resonator is lower and higher than the reference frequency the output of the integrator may be negative and positive respectively; and
an adder (44) for summing an output of the error amplifier (43) and an output of the low-frequency oscillator (40) and then supplying the result to the resonator length adjusting region (14) as its bias.

Also, the invention comprises an amplitude control device (45) for conducting control for adjusting an amplitude of a sine wave voltage applied from the low-frequency oscillator (40) to the resonator length adjusting region (14), which amplitude control device (45) is comprised of a variable attenuator for controlling the amplitude according to the magnitude of an error signal from the integrator (42), in such a setting that when the frequency is locked and stabilized to reduce an error to zero, an amplitude of a sine wave applied to the resonator length adjusting region may be reduced to zero or to such a small value as to maintain the locked state, to permit the adder (44) to sum an output of the amplitude control device (45) and an output of the error amplifier (43) and then output the result to the resonator length adjusting region (14) as a bias.

Such a configuration may be employed that an photo-current is taken out from the saturable absorbing region of the mode-locked semiconductor laser by capacitive coupling by use of bias tee to thereby extract a low-frequency noise component from that photo-current.

The following will describe the above-mentioned embodiments of the invention with reference to the drawings to further detail and specifically explain them.

### First Embodiment

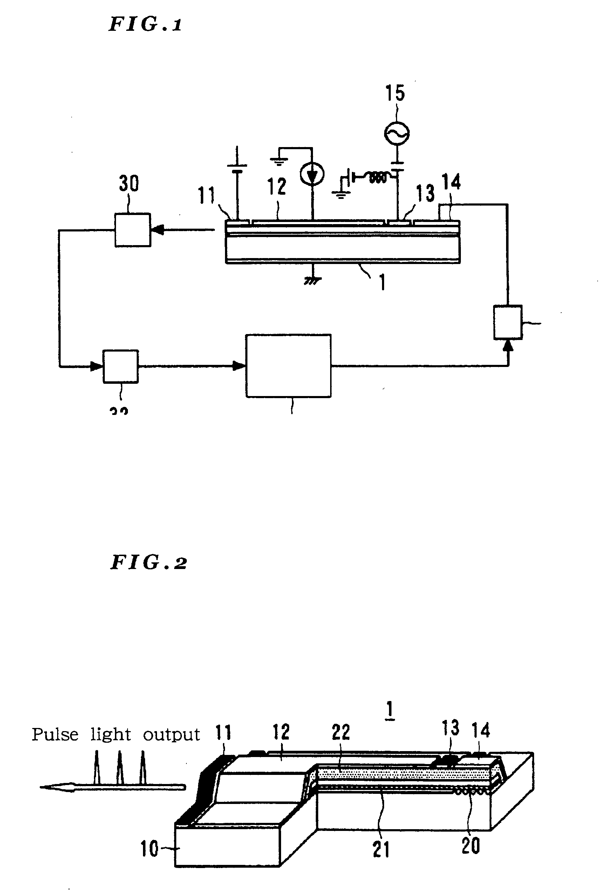

FIG. 1 is an illustration for explaining a method for driving a mode-locked semiconductor laser according to a first embodiment of the invention. The mode-locked semiconductor laser has a saturable absorbing region 11, a light amplification region 12, an optical modulation region 13, a resonator length adjusting region (distributed reflecting mirror) 14 integrated thereon.

Preferably, the saturable absorbing region 11 and the optical modulation region 13 should each be at an end of the resonator.

The resonator length adjusting region should be positioned inner than the optical modulation region in a structure of a passive wave guide but arbitrarily with respect to the light amplification region, while the distributed reflecting mirror 14 should be positioned at an end of the resonator as shown in FIG. 1.

When a reverse bias voltage is applied to the saturable absorbing region 11 and a current is injected to the light amplification region 12, passive mode-locking occurs.

The natural frequency of the mode-locked semiconductor laser is adjusted on the basis of a bias applied to the resonator length adjusting region 14.

Further, a sine wave having the reference frequency is applied from the oscillator 15 to the optical modulation region 13 to thereby carry out forced optical modulation.

If a shift is small between the natural frequency of the mode-locked semiconductor laser and the reference frequency, forced modulation can be carried out to obtain a hybrid mode-locking operation by which the frequency of the mode-locked semiconductor laser is locked to the reference frequency.

By a method for matching the natural frequency of the mode-locked semiconductor laser with the reference frequency according to this embodiment of the invention, the resonator length adjusting region is adjusted so as to minimize the intensity noise. For this purpose, outside the mode-locked semiconductor laser are provided a control loop comprised of a photo-electric conversion device 30, a noise detecting device 32, a control device 33, and a driving device 34.

An output light of the mode-locked semiconductor laser is converted at the photo-electric conversion device 31 into an electric signal, which is then sent to the noise detecting device 32, which extracts its low-frequency noise component.

The control device 33 controls the driving device 34 so as to minimize the intensity of this noise component, thus adjusting a bias applied to the resonator length adjusting region (distributed reflecting mirror) 14.

FIG. 2 is an illustration for showing one example of the configuration of a mode-locked semiconductor laser used in this embodiment of the invention. As shown in it, the mode-locked semiconductor laser has a four-electrode structure that comprises the light amplification region 12, the saturable absorbing region 11, the optical modulation region 13, and the distributed reflecting mirror 14. In this structure, on an n-InP substrate 10 is formed an active layer with a width of 1.5 µm, which is buried with a p-InP clad layer 22. Below the distributed reflecting mirror 14 is provided a diffraction grating 20 on the substrate 10.

This element structure is detailed for example in Japanese Patent Application Laid-Open No. Hei 10-359584. The following will describe about driving of a mode-locked semiconductor laser having its reference frequency equal to a frequency of 19.906 GHz of the Synchronous Digital Hierarchy (SDH), which is one of the communication frequency standards.

In this structure, the resonator measures 2120 µm in length as a whole, the saturable absorbing region 11 measures 100 µm in length, the optical modulation region 13 measures 120 µm in length, and the distributed reflecting mirror 14 measures 250 µm in length.

When a current was injected to the light amplification region 12 and a reverse bias voltage was applied to the saturable absorbing region 11, passive mode-locking occurred and, when a passive mode-locking state was entered under the conditions that a current of 60 mA was injected to the light amplification region 12 and a bias voltage of -0.7 V was applied to the saturable absorbing region with none of the electrodes of the distributed reflecting mirror 14 and the optical modulation region 13 being driven (with the terminal voltage being 0 V), a repetition pulse with a frequency of 19.5 GHz was obtained.

A shift from the reference frequency is corrected by adjusting the bias voltage applied (from the driving device 34) to the distributed reflecting mirror 14.

Since the active layer 21 of the distributed reflecting mirror 14 has a quantum well structure that has an absorption end at a wavelength of 1.48 µm, if an external electric field is applied to it, an absorption loss increases of a mode-locked pulsed light because of the electric field absorbing effect. This increase in the loss decreases the depth of the light penetrating into the distributed reflecting mirror 14 to thereby obtain an effect of actually shortening the resonator, thus enhancing the mode-locking frequency.

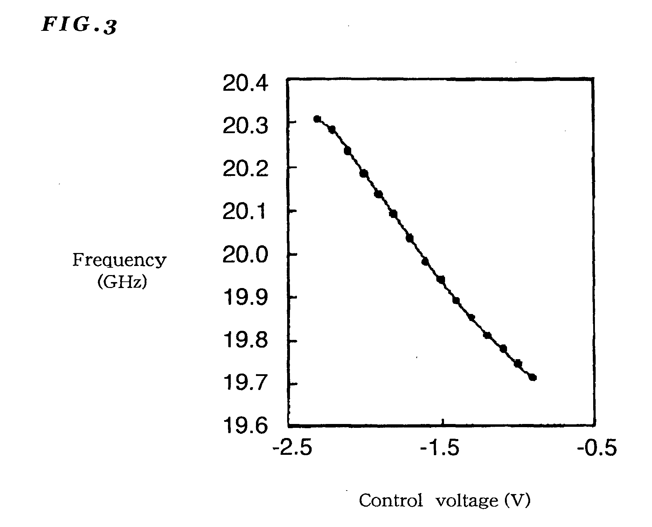

FIG. 3 is a graph for showing results of measuring a frequency under the conditions that a voltage applied to the distributed reflecting mirror 14 was changed with the fixed conditions of driving the light amplification region 12 and the saturable absorbing region 11.

As the reverse bias voltage on the distributed reflecting mirror 14 was changed, the frequency changed monotonously and, at a reverse bias voltage of -1.47 V, agreed with a frequency of 19.906 GHz.

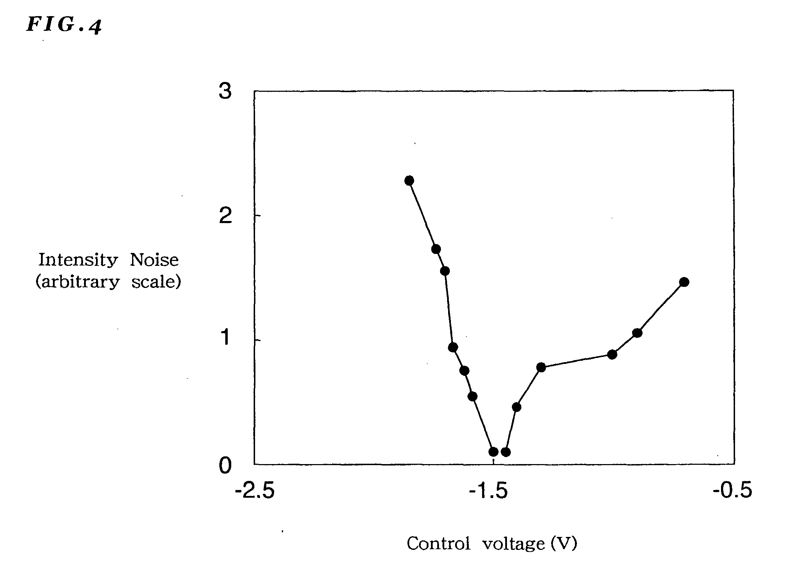

FIG. 4 is a graph for showing results of measuring a relationship between a degree of detuning with respect to the reference signal and intensity noise of a mode-locking frequency under the conditions that a voltage applied to the distributed reflecting mirror 14 was changed in a passive mode-locking state with a sine wave voltage of a synthesizer being applied to the optical modulation region 13 for carrying out forced modulation.

The intensity noise was measured as a voltage of a noise component of 2 GHz or lower extracted by the filter from an electric signal output when an output light was received by the photo-detector.

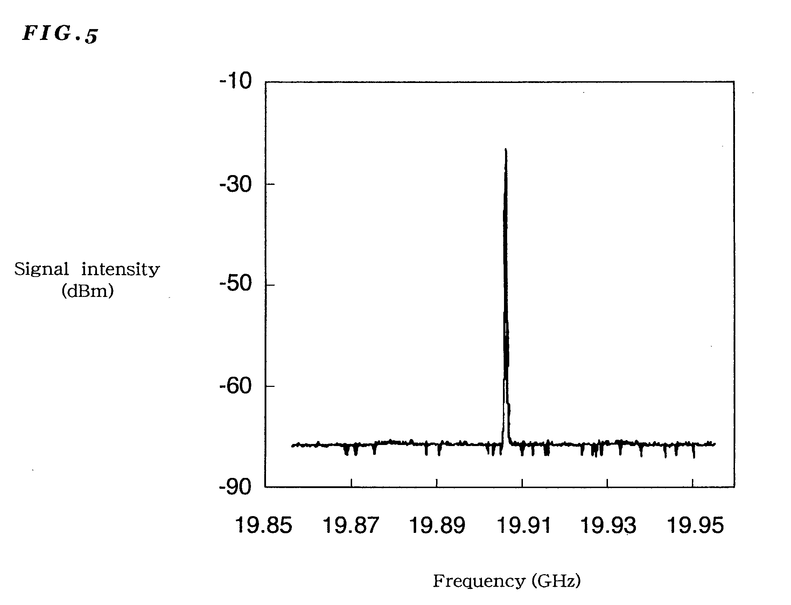

When the voltage applied to the distributed reflecting mirror 14 was in the vicinity of -1.5 V, the intensity noise hit a minimum, which can be correlated in FIG. 3 to the conditions under which the mode-locking frequency agreed with the reference frequency, indicating a hybrid mode-locking operation in which the frequency was locked to the reference frequency of 19.906 GHz by forced modulation, as can be observed from a frequency spectrum shown in FIG. 5.

The timing jitter indicating the stability of a frequency had a value of 0.22 pico-seconds, which is good enough for practical use.

The author measured the intensity noise based on the above results and confirmed that by adjusting the frequency so as to minimize it a driving operation can be carried out as matched with the reference frequency.

### Second Embodiment

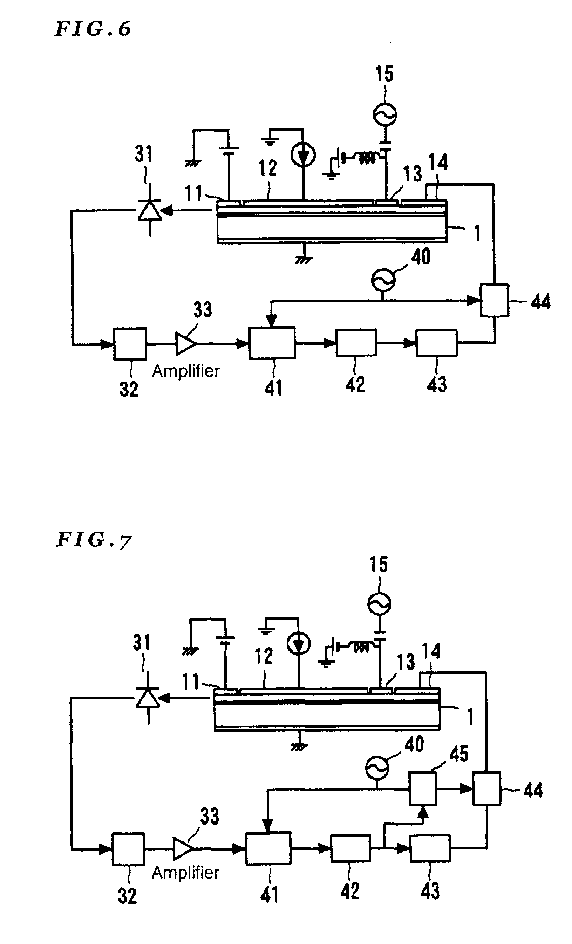

The following will describe a second embodiment of the invention. FIG. 6 is an illustration for showing a configuration of the second embodiment of the invention, specifically of a feed-back loop for automatically tunes a frequency. A method is described for matching the reference frequency and the natural frequency of a resonator.

To the distributed reflecting mirror 14 was applied a sine wave from a low-frequency oscillator 40, so that a change in intensity noise due to a change in frequency accompanied by a change in this sine wave voltage was detected and fed back. Then, an output of an error amplifier 43 and that of the low-frequency oscillator 40 are summed at an adder 44 and applied to the distributed reflecting mirror 14.

An output light pulse string is converted at the photo-detector 31 into an electric signal, which is then sent to the low-pass filter 32, which extracts only its low-frequency noise component.

Thus extracted noise component is multiplied at a multiplier 41 with a signal from the low-frequency oscillator 40 in a matched phase, the result of which multiplication is then integrated at an integrator 42.

The bias voltage applied to the distributed reflecting mirror 14 is adjusted at the error amplifier 43 in such a manner that this integration output may be negative and positive if the natural frequency of the resonator is lower and higher than the reference frequency respectively, thus being reduced to 0.

### Third Embodiment

The following will describe a third embodiment of the invention. FIG. 7 is an illustration for showing a configuration of the third embodiment of the invention, which is the same as that of the second embodiment shown in FIG. 6 except that it has an addition of an amplitude control device 45 for conducting control for adjusting an amplitude of a sine wave voltage applied from the low-frequency oscillator 40 to the distributed reflecting mirror 14.

The amplitude control device 45 is comprised of a variable attenuator for controlling an amplitude according to the magnitude of an error signal sent from the integrator 42 so that when the frequency is locked and stabilized to reduce the error to 0 the amplitude of a sine wave applied to the distributed reflecting mirror may be reduced to 0 or to such a small value as to maintain this locked state.

This prevents the frequency, once locked, from being modulated by a sine wave of the low-frequency oscillator 40 applied to the distributed reflecting mirror 14, thus improving the stability.

### Fourth Embodiment

The following will describe a fourth embodiment of the invention. FIG. 8 is an illustration for showing a configuration of the fourth embodiment of the invention. As shown in FIG. 8, photo-electric conversion is achieved by taking out a photo-current from the saturable absorbing region 11, rather than the photo-detector 31 employed in the configuration of the second embodiment shown in FIG. 6.

This gives almost the same effects and also further simplifies the configuration. Specifically, capacitive coupling is employed by use of bias tee to thereby extract a noise component in a form of an AC component. Note here that this configuration for taking out a photo-current from the saturable absorbing region 11 according to this embodiment is likewise applicable also to any other embodiments than that shown in FIG. 6.

The contents of the above-mentioned embodiments and the drawings are only illustrative and descriptive and so not restrictive, and it is intended to cover in the appended claims all variations and modifications which may occur to those skilled in the art as fall within the scope of the invention.

As described above, the invention has an effect that even over a wide frequency range, i.e. even if a difference is large between the reference frequency and the natural frequency of a mode-locked semiconductor laser, a frequency of that mode synchronous semiconductor laser can be matched in driving with that reference frequency, which has been impossible with a prior art driving method such as a PLL.

Thus, the invention enables employing only simple driving to obtain a light pulse source which operates at a frequency matched with the reference frequency of a communication system employed.

The invention may be embodied in other specific forms without departing from the spirit or essential characteristic thereof. The present embodiments are therefore to be considered in all respects as illustrative and not restrictive, the scope of the invention being indicated by the appended claims rather than by the foregoing description and all changes which come within the meaning and range of equivalency of the claims are therefore intended to be embraced therein.

The entire disclosure of Japanese Patent Application No. 2000-212510 (Filed on July 13, 2000) including specification, claims, drawings and summary are incorporated herein by reference in its entirety.

## Claims

1. A method for driving a mode-locked semiconductor laser having at least a light amplification region, a saturable absorbing region, a resonator length adjusting region, and an optical modulation region for forcedly modulating a light intensity externally, wherein when locking a repetition frequency of a light pulse output to a reference frequency, a signal having said reference frequency is applied to said optical modulation region to thereby adjust a bias applied to said resonator length adjusting region in such a manner as to minimize intensity noise of an output light.

2. A method for driving a mode-locked semiconductor laser having at least a light amplification region, a saturable absorbing region, a resonator length adjusting region, and an optical modulation region for forcedly modulating a light intensity externally, wherein when locking a repetition frequency of a light pulse output to a reference frequency, a signal having said reference frequency is applied to said optical modulation region to measure a component of low-frequency noise of a photo-current occurring at said saturable absorbing region to thereby adjust a bias applied to said resonator length adjusting region in such a manner as to minimize an intensity of said low-frequency noise.

3. A method for driving a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region, comprising the steps of:
applying a signal having a reference frequency from an oscillator to said optical modulation region to thereby carry out forced optical modulation;
extracting a low-frequency noise component from an output of said mode-locked semiconductor laser; and
controlling a driving device which supplies a bias to said resonator length adjusting region, so as to minimize an intensity of said noise component, thus adjusting a bias applied to said resonator length adjusting region.

4. A method for driving a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region, comprising the steps of:
applying a signal having a reference frequency from an oscillator to said optical modulation region to thereby carry out forced optical modulation;
extracting a low-frequency noise component from an output of said mode-locked semiconductor laser;
applying a low-frequency signal from a low-frequency oscillator to said resonator length adjusting region;
multiplying said noise component extracted previously with a signal from said low-frequency oscillator;
integrating said multiplication result;
permitting an error amplifier to adjust a bias applied to said resonator length adjusting region, so that said integration output may change a sign thereof according to whether said natural frequency is lower or higher than said reference frequency, thus be reduced to zero; and
summing an output of said error amplifier and an output of said low-frequency oscillator to then supply a resultant sum to said resonator length adjusting region as a bias.

5. The mode-locked semiconductor laser driving method according to Claim 1, wherein a sine wave signal having said reference frequency is applied to said optical modulation region.

6. The mode-locked semiconductor laser driving method according to Claim 1, wherein a bias applied to said resonator length adjusting region is in a form of voltage or current.

7. An apparatus for driving a mode-locked semiconductor laser having at least a light amplification region, a saturable absorbing region, a resonator length adjusting region, and an optical modulation region for forcedly modulating a light intensity externally, said apparatus comprising:
a signal applying device for, when locking a repetition frequency of a light pulse output to a reference frequency, applying a signal having said reference frequency to said optical modulation region;
a noise component extracting device for extracting a noise component from an output of said mode-locked semiconductor laser; and
a bias control device for adjusting a bias applied to said resonator length adjusting region so as to minimize said noise component.

8. An apparatus for driving a mode-locked semiconductor laser having at least a light amplification region, a saturable absorbing region, a resonator length adjusting region, and an optical modulation region for forcedly modulating a light intensity externally, said apparatus comprising:
a signal applying device for, when locking a repetition frequency of a light pulse output to a reference frequency, applying a signal having said reference frequency to said optical modulation region;
a noise detecting device for detecting a low-frequency noise component of a photo-current occurring at said saturable absorbing region; and
a bias controlling device for conducting control for adjusting a bias applied to said resonator length adjusting region so as to minimize an intensity of said low-frequency noise.

9. A mode-locked semiconductor laser driving apparatus comprising:
a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region;
an oscillator for applying a signal having a reference frequency to said optical modulation region to thereby carry out forced optical modulation;
a photo-detector for photo-electrically converting an output light of said mode-locked semiconductor laser into an electric signal;
a driving device for supplying a bias to said resonator length adjusting region;
a noise detecting device for receiving an output of said photo-detector as an input to thereby extract a low-frequency noise component; and
a control device for adjusting a bias applied to said resonator length adjusting region by controlling said driving device so that an intensity of said noise component detected by said noise detecting device may be minimized.

10. A mode-locked semiconductor laser driving apparatus comprising:
a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region;
an oscillator for applying a signal having a reference frequency to said optical modulation region to thereby carry out forced optical modulation;
a photo-detector for photo-electrically converting an output light of said mode-locked semiconductor laser into an electric signal;
a low-frequency oscillator for applying a low-frequency signal to said resonator length adjusting region;
a low-pass filter for receiving an output of said photo-detector as an input to thereby extract a low-frequency noise component;
a multiplier for multiplying said noise component extracted by said low-pass filter with a signal from said low-frequency oscillator;
an integrator for integrating an output of said multiplier, an output of said integrator changing a sign thereof according to whether said natural frequency is lower or higher than said reference frequency;
an error amplifier for receiving an output of said integrator as an input to thereby adjust a bias applied to said resonator length adjusting region, so that an output of said integrator may be reduced to zero; and
an adder for summing an output of said error amplifier and an output of said low-frequency oscillator to then supply a resultant sum to said resonator length adjusting region as a bias.

11. A mode-locked semiconductor laser driving apparatus comprising:
a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region;
an oscillator for applying a signal having a reference frequency to said optical modulation region to thereby carry out forced optical modulation;
a noise detecting device for utilizing capacitive coupling by use of bias tee to thereby take out a photo-current from said saturable absorbing region and then extract a low-frequency noise component from said photo-current;
a driving device for supplying a bias to said resonator length adjusting region;
a photo-detector for photo-electrically converting an output light of the mode-locked semiconductor laser into an electric signal
a noise detecting device for receiving an output of said photo-detector as an input to thereby extract a low-frequency noise component; and
a control device for adjusting a bias applied to said resonator length adjusting region by controlling said driving device so that an intensity of said noise component may be minimized.

12. A mode-locked semiconductor laser driving apparatus comprising:
a mode-locked semiconductor laser having at least a light amplification region, a saturable absorbing region, a resonator length adjusting region, and an optical modulation region in such a configuration that when a reverse bias voltage is applied to said saturable absorbing region and a current is injected to said light amplification region, passive mode-locking occurs, and a natural frequency is adjusted according to a bias applied to said oscillator length adjusting region;
an oscillator for applying a signal having a reference frequency to said optical modulation region to thereby carry out forced optical modulation;
a low-frequency oscillator for applying a low-frequency signal to said oscillator length adjusting region;
low-pass filter for utilizing capacitive coupling by use of bias tee to thereby take out a photo-current from said saturable absorbing region of said mode-locked semiconductor laser and then extract a low-frequency noise component from said photo-current;
a multiplier for multiplying said noise component extracted by said low-pass filter with a signal from said low-frequency oscillator;
an integrator for integrating an output of said multiplier, an output of said integrator changing a sign thereof according to whether said natural frequency is lower or higher than said reference frequency;
an error amplifier for receiving an output of said integrator as an input to thereby adjust a bias applied to said resonator length adjusting region, so that an output of said integrator may be reduced to zero; and
an adder for summing an output of said error amplifier and an output of said low-frequency oscillator to then supply a resultant sum to said resonator length adjusting region as a bias.

13. The mode-locked semiconductor laser driving apparatus according to Claim 10, comprising an amplitude control device for conducting control for adjusting amplitude of a signal applied from said low-frequency oscillator to said resonator length adjusting region, wherein:
said amplitude control device is comprised of a variable attenuator for controlling an amplitude according to a magnitude of an error signal from said integrator and is set so that when a frequency is locked and stabilized to reduce an error to zero an amplitude of a sine wave applied to said resonator length adjusting region may be reduced to zero or to such a small value as to maintain said locked state; and
said adder sums an output of said amplitude control device and an output of said error amplifier.

14. The mode-locked semiconductor laser driving apparatus according to Claim 7, wherein said oscillator applies a sine wave signal having a reference frequency to said optical modulation region to thereby carry out forced optical modulation.

15. The mode-locked semiconductor laser driving apparatus according to Claim 10, wherein said low-frequency oscillator applies a low-frequency sine wave signal to said resonator length adjusting region.

16. The mode-locked semiconductor laser driving apparatus according to Claim 10, wherein said multiplier multiples said noise component extracted by said low-pass filter with a signal from said low-frequency oscillator in a matched phase.

17. The mode-locked semiconductor laser driving apparatus according to Claim 7, wherein a bias applied to said resonator length adjusting region is in a form of voltage or current.

18. The mode-locked semiconductor laser driving apparatus according to Claim 7, wherein said resonator length adjusting has a distributed reflecting mirror.
